# EUROPEAN PATENT APPLICATION

(11) **EP 4 716 421 A1**
(43) Date of publication of application: **25.03.2026**
(21) Application number: 25201640.7
(22) Date of filing: 11.09.2025
(51) Int. Cl.: H10F 77/20, H10F 19/30, H10F 10/167

(54) **LAMINATED BODY AND SOLAR CELL**

(30) Priority: 20.09.2024 JP 2024164253
(71) Applicant: KABUSHIKI KAISHA TOSHIBA, Kawasaki-shi, Kanagawa, 212-0013 (JP)
(72) Inventor: HONISHI, Yuya, Kawasaki-shi, Kanagawa, (JP); SHIBASAKI, Soichiro, Kawasaki-shi, Kanagawa, (JP); WAKAMATSU, Kodai, Kawasaki-shi, Kanagawa, (JP); NAKAGAWA, Naoyuki, Kawasaki-shi, Kanagawa, (JP); WADA, Atsushi, Kawasaki-shi, Kanagawa, (JP); YOSHIO, Sara, Kawasaki-shi, Kanagawa, (JP); YAMAMOTO, Takashi, Kawasaki-shi, Kanagawa, (JP); MIZUNO, Yukitami, Kawasaki-shi, Kanagawa, (JP); TOYOTA, Motohiro, Kawasaki-shi, Kanagawa, (JP); NISHIDA, Yasutaka, Kawasaki-shi, Kanagawa, (JP); YAMAMOTO, Kazushige, Kawasaki-shi, Kanagawa, (JP)
(74) Representative: Hoffmann Eitle

(57) **Abstract**

A laminated body according to an embodiment includes a substrate, a transparent electrode provided on the substrate and an insulating film provided on the transparent electrode. The insulating film covers 50 % or more and 100% or less of a surface of the transparent electrode on the opposite side of the substrate. The insulating film has a thinner thickness of a thickness of the substrate.

## Description

### FIELD

Embodiments described herein relate generally to a laminated body, an electronic device, a solar cell, a multi-junction solar cell, a solar cell module, and a photovoltaic power generation system.

### BACKGROUND

One of new solar cells is a solar cell using a cuprous oxide (Cu₂O) for a light-absorbing layer. Cu₂O is a wide-gap semiconductor. Since Cu₂O is a safe and inexpensive material including copper which presents abundantly on the earth and oxygen, it is expected that a low-cost solar cell with high-efficiency can be realized.

### BRIEF DESCRIPTION OF THE DRAWINGS

FIG. 1 is a schematic cross-sectional diagram of a laminated body according to an embodiment;
FIG. 2 shows analysis spots of a laminated body according to an embodiment;
FIG. 3 is a schematic cross-sectional diagram of an electronic device according to an embodiment;
FIG. 4 is a schematic cross-sectional diagram of an electronic device according to an embodiment;
FIG. 5 is a schematic cross-sectional diagram of an electronic device according to an embodiment;
FIG. 6 is a schematic cross-sectional diagram of a solar cell according to an embodiment;
FIG. 7 is a schematic cross-sectional diagram of a multi-junction solar cell according to an embodiment;
FIG. 8 is a perspective diagram of a solar cell module according to an embodiment;
FIG. 9 is a schematic diagram of a solar cell module according to an embodiment;
FIG. 10 is a configuration diagram of a photovoltaic power generation system according to an embodiment;
FIG. 11 is a conceptual diagram of a vehicle according to an embodiment;
FIG. 12 is a schematic diagram of a drone according to an embodiment;
FIG. 13 is a table relating to examples;
FIG. 14 is a cross-sectional image of a solar cell according to an embodiment;
FIG. 15 is a cross-sectional image of a solar cell according to an embodiment;
FIG. 16 is a table relating to examples; and
FIG. 17 is a table relating to examples.

### DETAILED DESCRIPTION

A laminated body according to an embodiment includes a substrate, a transparent electrode provided on the substrate and an insulating film provided on the transparent electrode. The insulating film covers 50 % or more and 100% or less of a surface of the transparent electrode on the opposite side of the substrate. The insulating film has a thinner thickness of a thickness of the substrate.

Hereinafter, an embodiment will be described in detail with reference to the drawings. Unless otherwise specified, values at 25[°C] and 1 atm (atmosphere) are described. An average represents an arithmetic mean value. Each concentration is an average concentration in the region or layer of interest. In each layer, the presence of a specific element is, for example, an element whose presence can be confirmed by SIMS (Secondary Ion Mass Spectrometry), and the absence of a specific element is, for example, an element whose presence cannot be confirmed by SIMS.

In the specification, "/" (slash) represents the division sign excluding "/" of "and/or" representing "or". In the specification, "·" (middle dot, dot operator) and "×" represent a multiplication sign. In the specification, "." (period) of a numerical value represents a decimal point.

The thickness and structure of members described in the specification can be known, for example, from one or more of images obtained by SEM (Scanning Electron Microscope), TEM (Transmission Electron Microscope), HAADF-STEM: High-Angle Annular Dark Field Scanning Transmission Electron Microscopy), and the like. The boundaries of the members described in the specification can be determined from one or more images obtained by scanning electron microscopy or transmission electron microscopy, SEM-EDS (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEP, PL (Photoluminescence), XPS (X-ray Photoelectron Spectroscopy), or the like. These analysis methods are examples and do not negate the specific analytical methods described in the specification.

### (FIRST EMBODIMENT)

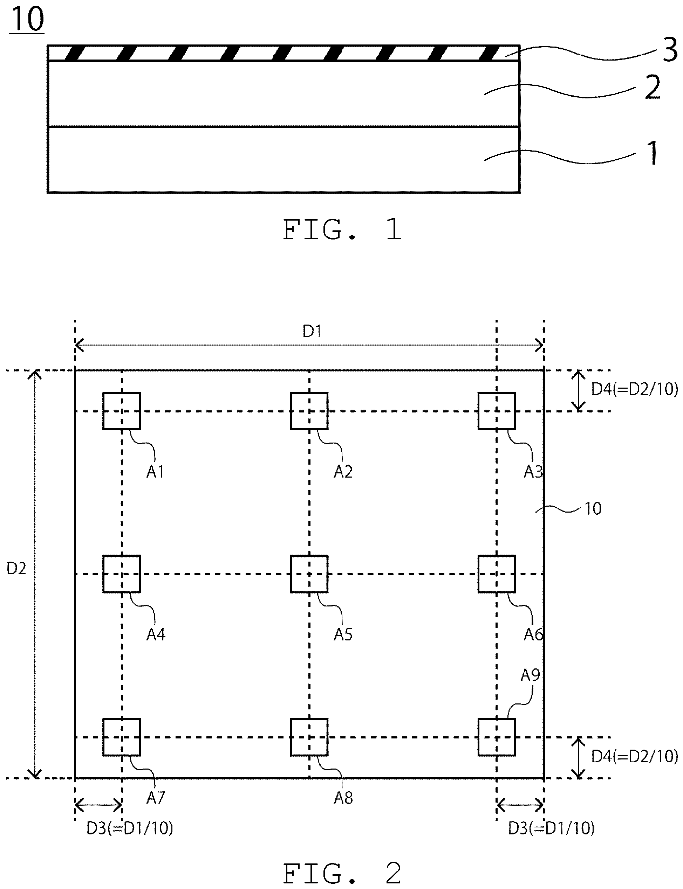

A first embodiment relates to a laminated body. FIG. 1 shows a schematic cross-sectional diagram of a laminated body. The laminated body 10 shown in the schematic cross-sectional diagram comprises a substrate 1, a transparent electrode 2, and an insulating film 3. The insulating film 2 covers 50 % or more and 100% or less of a surface of the transparent electrode 2 on the opposite side of the substrate 1. The insulating film 3 has a thinner thickness of a thickness of the substrate 1.

The substrate 1 is a transparent substrate. As the substrate 1 with light-transmittance, acrylic, polyimide, polycarbonate, polyethylene terephthalate (PET), polypropylene (PP), fluororesin (polytetrafluoroethylene (PTFE), perfluoroethylene propylene copolymer (FEP), ethylene tetrafluoroethylene copolymer (ETFE), polychlorotrifluoroethylene (PCTFE), perfluoroalkoxy alkane (PFA)), polyarylate, polysulfone, polyethersulfone, polyetherimide or inorganic substrate such as soda lime glass, float glass, chemically strengthened glass and quartz can be used. The substrate 1 may be a laminated body of the above substrates (materials).

The transparent electrode 2 is provided on the substrate 1 and is arranged between the substrate 1 and the insulating film 3. The transparent electrode 2 is a planar conductive film. The transparent electrode 2 is conductive layer having light transmittance. The transparent electrode 2 preferably includes one or more layers of transparent conductive oxide films.

The transparent conductive oxide film is not particularly limited, and is one or more semiconductor layers selected from the group consisting of an indium tin oxide (ITO), an Al-doped zinc oxide (AZO), a boron-doped zinc oxide (BZO), a gallium-doped zinc oxide (GZO), a doped tin oxide, a titanium-doped indium oxide (ITiO), an indium zinc oxide (IZO), an indium gallium zinc oxide (IGZO), a hydrogen-doped indium oxide (IOH), and the like. The transparent conductive oxide film may be a laminated film having multiple layers. A dopant for a film of tin oxide or the like is not particularly limited as long as the dopant is one or more elements selected from the group consisting of In, Si, Ge, Ti, Cu, Sb, Nb, Ta, W, Mo, F, Cl, and the like. The transparent electrode 2 preferably includes the doped tin oxide which is doped with one or more elements selected from the group consisting of In, Si, Ge, Ti, Cu, Sb, Nb, Ta, W, Mo, F, Cl, and the like. Considering heat resistance, it is preferable to use the Sb-doped tin oxide film for the transparent electrode 2. In the doped tin oxide film, one or more elements selected from the group consisting of In, Si, Ge, Ti, Cu, Sb, Nb, Ta, W, Mo, F, Cl, and the like are preferably included in an amount of 10 atomic % or less with respect to Zn included in the doped tin oxide film. As for the transparent electrode 2, a laminated film of the transparent conductive oxide film and a metal film can be used. The metal film of the transparent electrode 2 preferably has a thickness of 1 [nm] or more and 500 [µm] or less. The metal (including alloys) included in the metal film is not particularly limited to Mo, Au, Cu, Ag, Al, Ta, and W. Additionally, the transparent electrode 2 may include dot-shaped, line-shaped, or mesh-shaped electrodes (one or more selected from the group consisting of metals, alloys, graphene, conductive nitrides, and transparent conductive oxides) between the transparent conductive oxide film and the substrate 1. The dot-shaped metal, line-shaped metal, or mesh-shaped metal preferably has an opening ratio of 50% or more with respect to the transparent conductive oxide film. The dot-shaped metal, line-shaped metal, or mesh-shaped metal is not particularly limited to Mo, Au, Cu, Ag, Al, Ta, or W. When the metal film is used for the transparent electrode 2, the metal film preferably has a thickness of about 5 [nm] or less from the viewpoint of light transmittance. When the line-shaped or mesh-shaped metal film is used, above limitation does not apply to the film thickness of the metal film since light transmittance is secured at the openings.

A specific example of the transparent electrode 2 is a transparent electrode composed of an ITO film, or a laminated film of an ITO film and a doped tin oxide film where the doped tin oxide film is positioned on the insulating film 3 side.

The insulating film 3 is a film including an insulating material provided on the transparent electrode **2.** At least a part of the surface opposite to the substrate 1 side of the laminated body 10 (the side on which the insulating film 3 is provided) has electrical conductivity. The thickness direction of the insulating film 3 is the lamination direction of the laminated body 10.

The thickness of the transparent electrode 2 is preferably 50 [nm] or more and 500 [nm] or less, more preferably 50 [nm] or more and 300 [nm] or less, and even more preferably 75 [nm] or more and 200 [nm] or less. By using the insulating film 3, even when the thickness of the transparent electrode 2 is extremely thin, being 75 [nm] or more and 200 [nm] or less, the sheet resistance in a device utilizing the laminated body 10 can be lowered.

The insulating film 3 is in direct contact with the transparent electrode 2. The insulating film 3 is in direct contact with the surface of the transparent electrode 2 on the side opposite to the substrate 1 side (the side facing the insulating film 3). It is preferable that the transparent electrode 2 includes an oxide transparent conductive film positioned most closely to the insulating film 3 side, and that the insulating film 3 is in direct contact with the surface of the oxide transparent conductive film positioned most closely to the insulating film 3 side on the transparent electrode 2, opposite to the substrate 1 side.

It is preferable that the surface of the insulating film 3 facing the transparent electrode side 2 is in direct contact with the transparent electrode 2. It is preferable that the entire surface of the insulating film 3 facing the transparent electrode 2 side is in direct contact with the transparent electrode 2.

It is preferable that the insulating film 3 covers 50% or more and 100% or less of the surface on the transparent electrode 2 side opposite to the substrate 1 side, more preferably 95% or more and 100% or less, and even more preferably 99% or more and 100% or less.

The insulating film 3 can cover the entire surface of the transparent electrode 2 side opposite to the substrate 1 side.

It is preferable that the insulating film 3 includes one or more selected from the group consisting of SiO₂, Al₂O₃, SiN, SiON, and MgO as an insulating material. The insulating film 3 is so-called glass or ceramics. The insulating film 3 is preferably composed of an inorganic material. It is preferable that the insulating film 3 is an amorphous film.

It is preferable that the insulating film 3 includes one or more selected from the group consisting of SiO₂, Na₂O, CaO, B₂O₃, Al₂O₃, SiN, SiON, and MgO, and the total amount of one or more selected from the group consisting of SiO₂, Na₂O, CaO, B₂O₃, Al₂O₃, SiN, SiON, and MgO included in the insulating film 3 is 70 [wt%] or more and 100 [wt%] or less (where the total weight of the insulating film is regarded as 100 [wt%]). The insulating film 3 may include oxides such as Li₂O, K₂O, CaO, BaO, SrO, ZnO, ZrO₂, PbO, TiO₂, HfO₂, and Sb₂O₃ in addition to the above-mentioned oxides.

When the total amount of one or more selected from the group consisting of SiO₂, Na₂O, CaO, B₂O₃, Al₂O₃, SiN, SiON, and MgO included in the insulating film 3 is 95 [wt%] or more and 100 [wt%] or less(where the total weight of the insulating film 3 is regarded as 100 [wt%]), it is preferable that the total amount of one or more selected from the group consisting of SiO₂, Al₂O₃, SiN, SiON, and MgO included in the insulating film 3 is 50 [wt%] or more and 100 [wt%] or less, and more preferably 60 [wt%] or more and 100 [wt%] or less.

It is preferable that the insulating film 3 includes one or more selected from the group consisting of SiO₂, Na₂O, CaO, B₂O₃, Al₂O₃, and MgO, and the total amount of one or more selected from the group consisting of SiO₂, Na₂O, CaO, B₂O₃, Al₂O₃, and MgO included in the insulating film 3 is 70 [wt%] or more and 100 [wt%] or less(where the total weight of the insulating film 3 is regarded as 100 [wt%]). It is preferable that the total amount of one or more selected from the group consisting of SiO₂, Al₂O₃, and MgO included in the insulating film 3 is 50 [wt%] or more and 100 [wt%] or less, and more preferably 60 [wt%] or more and 100 [wt%] or less.

It is preferable that the total amount of one or more selected from the group consisting of SiO₂, Na₂O, CaO, B₂O₃, Al₂O₃, and MgO included in the insulating film 3 is 70 [wt%] or more and 100 [wt%] (where the total weight of the insulating film 3 is regarded as 100 [wt%]) or less, and it is preferable that the total amount of SiO₂ and Al₂O₃ included in the insulating film 3 is 50 [wt%] or more and 100 [wt%] or less, and more preferably 60 [wt%] or more and 100 [wt%] or less.

It is preferable that the total amount of one or more selected from the group consisting of SiO₂, Na₂O, CaO, B₂O₃, Al₂O₃, and MgO included in the insulating film 3 is 70 [wt%] or more and 100 [wt%] or less (where the total weight of the insulating film is regarded as 100 [wt%]), and it is preferable that the amount of SiO₂ included in the insulating film 3 is 50 [wt%] or more and 100 [wt%] or less, and more preferably 60 [wt%] or more and 100 [wt%] or less.

It is preferable that the total amount of one or more selected from the group consisting of SiO₂, Na₂O, CaO, B₂O₃, Al₂O₃, and MgO included in the insulating film 3 is 70 [wt%] or more and 100 [wt%]or less (where the total weight of the insulating film is regarded as 100 [wt%]), and it is preferable that SiO₂ is the most abundant compound included in the insulating film 3, and the total amount of SiO₂ and Al₂O₃ included in the insulating film 3 is 50 [wt%] or more and 100 [wt%] or less, and more preferably 60 [wt%] or more and 100 [wt%] or less.

It is preferable that the total amount of one or more selected from the group consisting of SiO₂, Na₂O, CaO, B₂O₃, Al₂O₃, and MgO included in the insulating film 3 is 70 [wt%] or more and 100 [wt%] or less (where the total weight of the insulating film is regarded as 100 [wt%]), and it is preferable that SiO₂ is the most abundant compound included in the insulating film 3, and the amount of SiO₂ included in the insulating film 3 is 50 [wt%] or more and 100 [wt%] or less, and more preferably 60 [wt%] or more and 100 [wt%] or less.

It is preferable that the insulating film 3 has SiO₂ or Al₂O₃ as its main component (the compound with the highest compositional ratio [wt%] among the compounds included in the insulating film 3). Soda-lime glass (e.g., including SiO₂ as the main component, additionally Na₂O and CaO), SiO₂, Al2O₃, float glass (e.g., including SiO₂ as the main component, additionally Na₂O, K₂O, CaO, BaO, ZnO, TiO₂, and Sb₂O₃), aluminosilicate glass (e.g., including SiO₂ as the main component, additionally CaO and B₂O₃) or borosilicate glass (e.g., including SiO₂ as the main component, additionally Na₂O, Al₂O₃, and B₂O3) are preferable, with soda-lime glass or SiO₂ being more preferable.

The composition of the insulating film 3, etc. can be determined by analyzing analysis spots (A1 to A9), which are distributed as evenly and densely as possible, as shown in a diagram explaining the analysis spots of FIG. 2, using TEM-EDS (Transmission Electron Microscopy - Energy Dispersive X-ray Spectroscopy), for example. FIG. 2 is a schematic diagram showing the laminated body 10 viewed from the side of the insulating film 3. When analyzing the composition of the laminated body 10, D1 represents the length in the width direction (long side) of the laminated body 10, and D2 represents the length in the depth direction (short side) of the laminated body 10. By magnifying with TEM to 2 million times and observing a cross sectional region including the center of each analysis spot with a size of 100 [nm] × 100 [nm], the thickness of the insulating film 3, etc., can be determined. The composition can also be determined from the element mapping obtained by EDS. Furthermore, each center of the analysis spots can be analyzed in the thickness direction of the laminated body 10 with XPS (X-ray Photoelectron Spectroscopy) to evaluate the chemical bonding state and identify the compounds of elements included in the insulating film 3.

The insulating film 3 is thinner than the substrate 1. It is preferable that the average thickness of the insulating film 3 is 10⁻⁸ times or more and 10⁻³ times or less the thickness of the substrate 1, and more preferably 5 × 10⁻⁷ times or more and 5 × 10⁻³ times or less, and even more preferably 5 × 10⁻⁷ times or more and 5 × 10⁻⁴ times or less. It is preferable that the thickness of the insulating film 3 is 1 [nm] or more and 50 [nm] or less, more preferably 1 [nm] or more and 30 [nm] or less, and even more preferably 3 [nm] or more and 20 [nm] or less.

The thickness of the insulating film 3 is determined by observing a cross-sectional image of the laminated body 10 in the thickness direction. The area S [nm²] of the insulating film 3 present within a length of 10 nm of the cross-sectional image is determined. Subsequently, the average thickness of the insulating film 3 with a length of 10 [nm] is obtained dividing by the value of the area S [nm²] by 10. With the width of one analysis spot set at 100 [nm], 10 values of the above average thicknesses can be determined per analysis spot. Similarly, determining the thickness in nine analysis spots allows for determining 90 values of the above average thicknesses for one laminated body 10. For example, when the insulating film 3 has a thickness of 1 [nm] or more and 50 [nm] or less, this means that all 90 above average thicknesses of the insulating film 3 satisfy the range of 1 [nm] or more and 50 [nm] or less. The average thickness of the insulating film 3 is the average value of these 90 values of the above average thicknesses. The maximum thickness of the insulating film 3 is the maximum value among these 90 above average thicknesses. A portion of the insulating film 3 where a thickness is less than 0.1 [nm] is considered to be a portion where the insulating film 3 is not provided on the transparent electrode 2. Due to the analysis method, the lower limit of the thickness of the insulating film 3 is set at 0.1 [nm].

It is preferable that the average thickness of the insulating film 3 is 1 [nm] or more and 30 [nm] or less, more preferably 1.5 [nm] or more, even more preferably 3 [nm] or more and 25 [nm] or less, and further more preferably 5 [nm] or more and 20 [nm] or less.

It is preferable that the average thickness of the insulating film 3 is 1 [nm] or more and 10 [nm] or less, more preferably 1.5 [nm] or more and 10 [nm] or less, even more preferably 3 [nm] or more and 25 [nm] or less, and further more preferably 5 [nm] or more and 20 [nm] or less.

It is preferable that the minimum thickness of the insulating film 3 is 0.1 times or more and 1 times or less the average thickness of the insulating film 3, more preferably 0.3 times or more and 1 times or less, and even more preferably 0.5 times or more and 1 times or less.

It is preferable that the maximum thickness of the insulating film 3 is 1 times or more and 10 times or less the average thickness of the insulating film 3, more preferably 1 times or more and 5 times or less, and even more preferably 1 times or more and 3 times or less.

It is preferable that the distribution of the thickness of the insulating film 3 has a maximum peak within the range of 5 [nm] or more and 15 [nm] or less. When another peak exists in addition to the maximum peak within the range of 5 [nm] or more and 15 [nm] or less, it is preferable that the height of the other existing peaks is 50% or less of the height of the maximum peak. The half-value width of the thickness distribution of the insulating film 3 is preferably 1 [nm] or more and 10 [nm] or less.

The side of the laminated body 10 opposite to the surface facing the transparent electrode 2 is exposed.

For example, the laminated body 10 can be obtained by forming the transparent electrode 2 on the substrate 1 by sputtering and forming the insulating film 3 on the transparent electrode 2 by a sputtering method or an ALD (Atomic Layer Deposition) method, etc.

It is preferable that the transmittance of light of the laminated body 10 using the transparent electrode 2 in a wavelength band of 700 [nm] or more and 1000 [nm] or less is 65% or more, and the transmittance of light in a wavelength band of 800 [nm] or more and 1000 [nm] or less is 70% or more.

The laminated body 10 with the insulating film 3 is transparent. After forming a semiconductor layer, etc., on the insulating film 3, the side of the insulating film 3 can be electrically contactable with the transparent electrode 2, and it can be used similarly to materials in which the insulating film 3 substantially does not exist. When a semiconductor layer, etc., is formed on the laminated body 10, the insulating film 3 functions as a barrier layer preventing diffusion of elements from the semiconductor layer, etc., to the transparent electrode 2 and is considered to contribute to preventing an increase in resistance of the transparent electrode 2.

### (SECOND EMBODIMENT)

A second embodiment relates to an electronic device. The electronic device of the second embodiment comprises the laminated body 10 and a liquid crystal layer, a light emitter layer, or a semiconductor layer provided on the insulating film 3 of the laminated body 10. By forming a semiconductor layer or the like on the insulating film 3, the thickness of the insulating film 3 in this embodiment may differ from that of the insulating film 3 in the first embodiment. While the insulating film 3 in the first embodiment does not have sections with a thin thickness and sections with a thick thickness, the insulating film 3 in this embodiment has one or more sections with a thin thickness (thin section) and one or more sections with a thick thickness (thick section). The thickness of the insulating film 3 in the first embodiment is different from the thickness of the insulating film 3 in this embodiment.

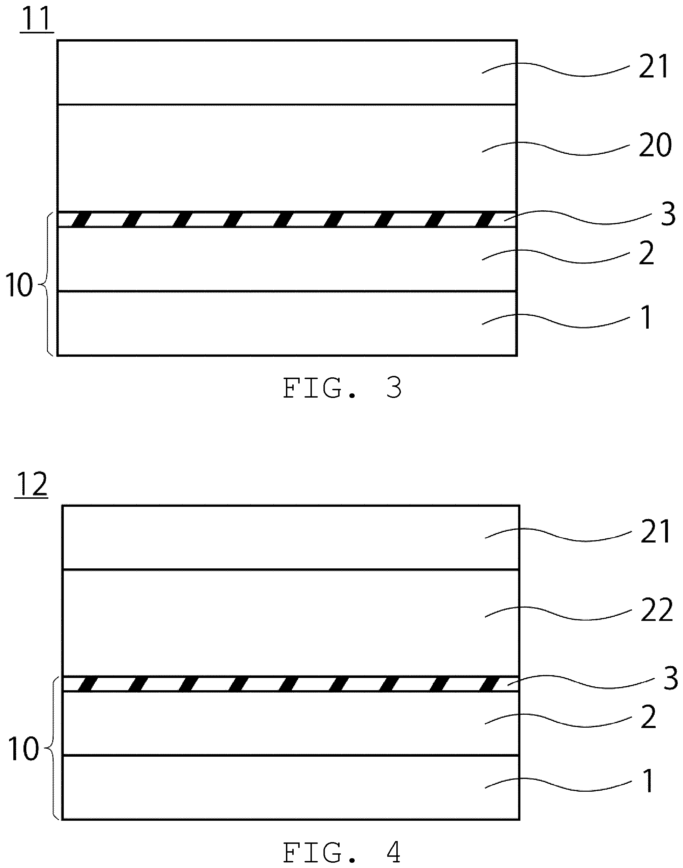

FIG. 3 shows a cross-sectional schematic diagram of an electronic device 11 having a liquid crystal layer 20. The electronic device 11 comprises the laminated body 10, the liquid crystal layer 20, and an electrode 21. The electronic device 11 is, for example, a display (monitor). The liquid crystal layer 20 is positioned between the insulating film 3 of the laminated body 10 and the electrode 21. For example, the liquid crystal layer 20 comprises liquid crystals sandwiched between alignment films. The liquid crystal layer 20 is electrically connected to the transparent electrode 2 of the laminated body 10. The laminated body 10 is suitable as a substrate provided with an electrode for a display.

FIG. 4 shows a cross-sectional schematic diagram of an electronic device 12 comprising a light emitter layer 22. The electronic device 12 comprises the laminated body 10, the light emitter layer 22, and an electrode 21. The electronic device 12 is, for example, a display. The light emitter layer 22 is positioned between the insulating film 3 of the laminated body 10 and the electrode. For example, the light emitter layer 22 comprises a polymer light-emitting layer and a hole injection layer. The polymer light-emitting layer or the hole injection layer of the light emitter layer 22, for example, is electrically connected to the transparent electrode 2 of the laminated body 10. The laminated body 10 is suitable as a substrate provided with electrodes for a display.

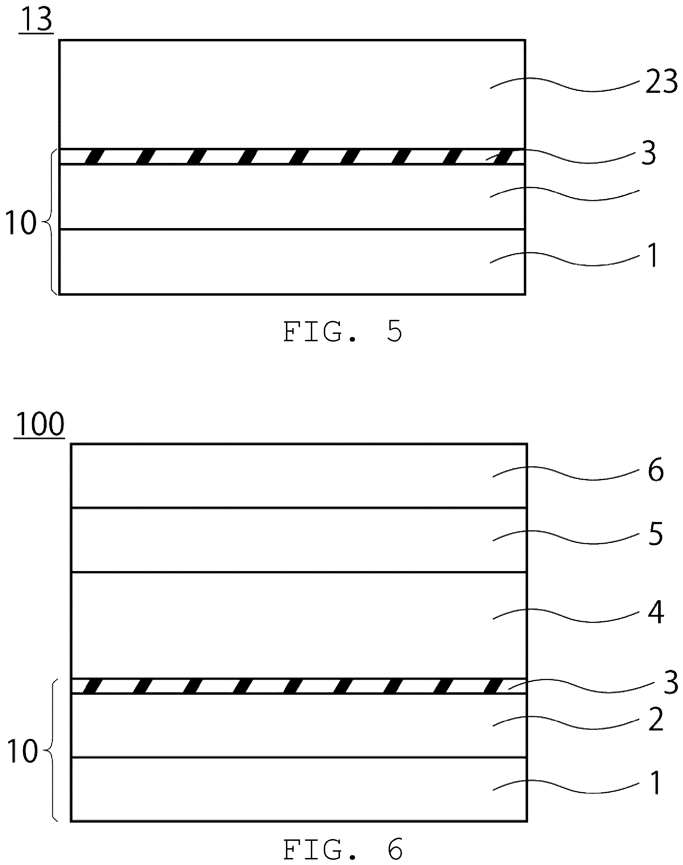

FIG. 5 shows a cross-sectional schematic diagram of an electronic device 13 having a semiconductor layer 23. The electronic device 13 comprises the laminated body 10 and the semiconductor layer 23. The electronic device 13 is, for example, used for a semiconductor device including a solar cell. The semiconductor layer 23, for example, comprises a compound semiconductor. The semiconductor layer 23 is electrically connected to the transparent electrode 2 of the laminated body 10. The laminated body 10 is suitable as a substrate provided with electrodes for a semiconductor device.

The insulating film 3 of the second embodiment includes, at least partially, the sections with a thin thickness where electric current can flow in the thickness direction of the laminated body 10 structure through which an electric current can flow. The liquid crystal layer 20 of the electronic device 11 is electrically connected to the transparent electrode 2. The light emitter layer 22 of the electronic device 12 is electrically connected to the transparent electrode 2. The semiconductor layer 23 of the electronic device 13 is electrically connected to the transparent electrode 2.

The insulating film 3 is a film comprising an insulating material formed on the transparent electrode 2. At least partially, the insulating film 3 has electrical conductivity. The thickness direction of the insulating film 3 is the stacking direction of the insulating film 3 and the liquid crystal layer 20, the light emitter layer 22, or the semiconductor layer 23.

The insulating film 3 is in direct contact with the transparent electrode 2. The insulating film 3 is in direct contact with the surface of the transparent electrode 2 on the side opposite to the substrate 1 side (the surface of the transparent electrode 2 on the side of the insulating film 3). It is preferable that the transparent electrode 2 includes an oxide transparent conductive film on the side most closely to the insulating film 3, and the insulating film 3 is in direct contact with the surface of the oxide transparent conductive film most closely to the insulating film 3 on the side opposite to the substrate 1 side of the oxide transparent conductive film.

It is preferable that the surface of the insulating film 3 facing the transparent electrode 2 is in direct contact with the transparent electrode 2. It is more preferable that the entire surface of the insulating film 3 facing the transparent electrode 2 is in direct contact with the transparent electrode 2.

It is preferable that the insulating film 3 covers 50% or more and 100% or less of the surface of the transparent electrode 2 on the side opposite to the substrate 1 side, more preferably 95% or more and 100% or less, and even more preferably 99% or more and 100% or less.

The insulating film 3 can cover the entire surface of the transparent electrode 2 on the side opposite to the substrate 1 side.

The thin sections of the insulating film 3 are considered to allow electricity to flow due to the tunnel effect. The insulating film 3 also includes thick sections, which have lower electrical conductivity than the thin sections. The thick sections are thought to function as a barrier layer for the transparent electrode 2.

To provide electrical conductivity on the side opposite to the substrate 1 side of the laminated body 10, the thickness of the thin sections of the insulating film 3 included in the insulating film 3 is 0.1 [nm] or more and less than 3.0 [nm]. The thin sections of the insulating film 3 has a thickness in the range of 0.1 [nm] or more and less than 3.0 [nm]. The thickness of the insulating film 3 is determined by the method described in the first embodiment.

It is preferable that the average thickness of the thin sections of the insulating film 3 is 0.2 [nm] or more and 2.8 [nm] or less, more preferably 0.5 [nm] or more and 2.5 [nm] or less, and even more preferably 0.5 [nm] or more and 2.0 [nm] or less.

The average thickness of the insulating film 3 is referred to as the average thickness of the insulating film 3. It is preferable that the average thickness of the insulating film 3 is 1 [nm] or more and 15 [nm] or less, more preferably 1.5 [nm] or more and 12.5 [nm] or less, and even more preferably 2.5 [nm] or more and 10 [nm] or less.

It is preferable that the average thickness of the insulating film 3 is 2 times or more and 75 times or less the average thickness of the thin sections of the insulating film 3, more preferably 5 times or more and 50 times or less, and even more preferably 5 times or more and 25 times or less.

It is preferable that the thickness distribution of the insulating film 3 has peaks in the ranges of 0.1 [nm] or more and 3.0 [nm] or less and 3.0 [nm] or more and 20 [nm] or less, respectively.

The insulating film 3 is preferably provided to smooth at least a portion of the height difference of the surface unevenness of the transparent electrode 2. For example, the average thickness of the insulating film 3 on the grain boundary portion of the transparent electrode 2 is preferably 1.5 times or more and 10 times or less the average thickness of the insulating film 3.

The thickness of the thick sections of the insulating film 3 is 3.0 [nm] or more and 20 [nm] or less. The thickness of the thick sections of the insulating film 3 has a thickness in the range of 3.0 [nm] or more and 20 [nm] or less. It is preferable that the average thickness of the thick sections of the insulating film 3 is 3.5 [nm] or more and 18 [nm] or less, more preferably 4.0 [nm] or more and 15 [nm] or less, and even more preferably 4.0 [nm] or more and 10 [nm] or less.

It is preferable that the average thickness of the thick sections of the insulating film 3 is 1.1 times or more and 10 times or less the average thickness of the insulating film 3, more preferably 1.2 times or more and 8 times or less, and even more preferably 1.3 times or more and 5 times or less.

The insulating film 3 may have a portion exceeding the thickness of the thick sections. Including the case where the insulating film 3 has a portion exceeding the thickness of the thick sections, it is preferable that the maximum thickness of the insulating film 3 is 15 [nm] or more and 50 [nm] or less, more preferably 15 [nm] or more and 30 [nm] or less, and even more preferably 15 [nm] or more and 20 [nm] or less.

It is preferable that the minimum thickness of the insulating film 3 is 0.1 [nm] or more and less than 3.0 [nm].

The ratio of the thin sections of the insulating film 3 ([the number of the 90 values of the thicknesses described in the first embodiment where the thickness of the insulating film 3 is 0.1 [nm] or more and less than 3.0 [nm] ] / 90) is preferably 10% or more and 90% or less, more preferably 20% or more and 90% or less, and even more preferably 30% or more and 90% or less.

The ratio of the thick sections of the insulating film 3 ([the number of the 90 values of the thicknesses described in the first embodiment where the thickness of the insulating film 3 is 3.0 [nm] or more and 20 [nm] or less] / 90) is preferably 10% or more and 90% or less, more preferably 10% or more and 80% or less, and even more preferably 10% or more and 70% or less.

The ratio of the thin sections of the insulating film 3 is preferably 0.3 times or more and 5 times or less the ratio of the thick sections of the insulating film 3, and even more preferably 0.5 times or more and 4 times or less.

When the insulating film 3 includes a portion thicker than 20 [nm] and/or the surface opposite to the substrate 1 side of the transparent electrode 2 is covered by less than 100% of the insulating film 3, [the ratio of thin sections of the insulating film 3] + [the ratio of thick sections of the insulating film 3] will not be 100%.

### (THIRD EMBODIMENT)

A third embodiment relates to a solar cell. A solar cell is a specific example of an electronic device. FIG. 6 shows a schematic cross-sectional diagram of a solar cell 100 according to the third embodiment. As shown in FIG. 6, the solar cell 100 according to this embodiment comprises a laminated body 10 having a substrate 1, a first electrode which is a transparent electrode 2, and an insulating film 3; a p-type light-absorbing layer 4; an n-type layer 5; and a second electrode which is an n-electrode 6. The insulating film 3 is the same as the insulating film 3 in the second embodiment (including thin sections and thick sections). The first electrode, which is the transparent electrode 2, acts as a p-electrode. Intermediate layers not shown in the figure may be incorporated between the p-type light-absorbing layer 4 and the n-type layer 5, or between the n-type layer 5 and the n-electrode 6. Sunlight may enter from either the n-electrode 6 side or the transparent electrode 2 side, but it is preferable for sunlight to enter from the n-electrode 6 side. The solar cell 100 of this embodiment is a translucent solar cell and is therefore preferably used as the top cell side (light incident side) of a multi-junction solar cell. The following description will be given with reference to the form shown in FIG. 6, but a configuration where the substrate 1 is located at a different position is similarly applicable even when the substrate 1 is provided on the n-electrode 6 side. In the solar cell 100 of this embodiment, light enters from the n-electrode 6 side toward the transparent electrode 2 side.

When transparent electrodes are used for the transparent electrode 2 and n-electrode 6 in the embodiment of the solar cell 100, the transmittance of light in a wavelength band of 700 [nm] or more and 1200 [nm] or less is high, and the color may be red (reddish brown), yellow, or orange.

The p-type light-absorbing layer 4 is overall a p-type semiconductor layer. The p-type light-absorbing layer 4 is provided on the transparent electrode 2. It is preferable that the p-type light-absorbing layer 4 is in direct contact with the transparent electrode 2 and/or the insulating film 3. The p-type light-absorbing layer 4 is provided between the insulating film 3 and the n-type layer 5. The p-type light-absorbing layer 4 facing the n-type layer 5 side, not the entire surface, is preferably in direct contact with a part of the n-type layer 5. It is preferable that the p-type light-absorbing layer 4 in direct contact with the n-type layer 5 forms a pn junction with the n-type layer 5. The p-type light-absorbing layer 4 includes a cuprous oxide compound as a main component. Preferably, the cuprous oxide compound has a chalcopyrite structure.

It is preferable that the p-type light-absorbing layer 4 is a semiconductor layer comprising a cuprous oxide compound. More preferably, the p-type light-absorbing layer 4 is polycrystalline cuprous oxide. The p-type light-absorbing layer 4 may contain one or more impurities selected from the group consisting of copper (Cu), copper oxide (CuO), and copper hydroxide (Cu(OH)₂) in trace amounts as impurities.

When all elements other than oxygen are set to 100 [atomic%], the cuprous element contained in the p-type light-absorbing layer 4 is preferably 90% or more and less than 100%, more preferably 95% or more and less than 100%, even more preferably 98% or more and less than 100%, and most preferably 99% or more and less than 100%.

When all elements other than oxygen are set to 100%, the cuprous element contained in the p-type light-absorbing layer 4 is preferably 90% or more and 99.9% or less, more preferably 95.0% or more and 99.9% or less, even more preferably 98% or less and 99.9% or less, and most preferably 99.0% or more and 99.9% or less.

The cuprous oxide compound includes copper and oxygen and may optionally include an element represented by M1. The element represented by M1 is preferably one or more elements selected from the group consisting of Cl, F, Br, I, Sn, Sb, Ag, Li, Na, K, Cs, Rb, Al, In, Zn, Mg, Ga, Si, Ge, N, P, B, Ti, Hf, Zr, and Ca.

The number of oxygen atoms contained in the cuprous oxide compound is preferably 0.48 or more and 0.56 or less when the number of copper atoms is 1. When there is excessive oxygen relative to copper, the ratio of copper oxide contained in the cuprous oxide compound increases, narrowing the band gap and reducing the transmittance of the p-type light-absorbing layer 4. When there is insufficient oxygen relative to copper, the copper content in the cuprous oxide compound increases, leading to a decrease in transmittance. In addition, when the ratio of oxygen to copper does not fall within the above range, it becomes difficult for the cuprous oxide compound to have a chalcopyrite structure.

It is preferable that 95 [wt%] or more and less than 100 [wt%] of the p-type light-absorbing layer 4 comprises cuprous oxide. More preferably, 98 [wt%] or more and less than 100 [wt%] of the p-type light-absorbing layer 4 comprises cuprous oxide. Even more preferably, 99 [wt%] or more and 100 [wt%] or less of the p-type light-absorbing layer 4 comprises cuprous oxide. The p-type light-absorbing layer 4 can be composed entirely of cuprous oxide (100 [wt%]).

The transmittance of the p-type light-absorbing layer 4 increases when it has few defects and good crystallinity, which is preferable. By including elements other than Cu and O in the p-type light-absorbing layer 4, the band gap of the p-type light-absorbing layer 4 can be adjusted. The band gap of the p-type light-absorbing layer 4 is preferably 2.0 [eV] or more and 2.2 [eV] or less. Within this range, solar light can be efficiently utilized by both the top cell of the embodiment and bottom cell (Si used as a light absorption layer) in a multi-junction solar cell. It is preferable for the p-type light-absorbing layer 4 to contain Sn and/or Sb. The Sn or Sb in the p-type light-absorbing layer 4 may be added to it, or it may originate from the transparent electrode 2. Ga contained in the p-type light-absorbing layer 4 is not included in the raw materials for forming the p-type light-absorbing layer 4 but rather diffused from Ga contained in the n-type layer 5. Other elements used during the formation of the n-type layer 5 may also diffuse into the p-type light-absorbing layer 4.

The composition ratio of the p-type light-absorbing layer 4 refers to the overall composition ratio of the p-type light-absorbing layer 4. It is preferable that this compound composition ratio of the p-type light-absorbing layer 4 is satisfied as a whole within the p-type light-absorbing layer 4.

It is preferable for the p-type light-absorbing layer 4 to have a p+ (p plus) type region on the transparent electrode 2 side of the p-type light-absorbing layer 4.

It is preferable for the p-type light-absorbing layer 4 to have a p- (p minus) type region on the n-type layer 5 side of the p-type light-absorbing layer 4.

It is preferable for the p-type light-absorbing layer 4 to have a p- type region on the n-type layer 5 side and a p+ type region on the transparent electrode 2 side.

The composition of the p-type light-absorbing layer 4 is determined as follows. "d1" represents the thickness of the p-type light-absorbing layer 4. The composition at each of positions at a first depth, a second depth, a third depth, a fourth depth, a fifth depth, a seventh depth, a eighth depth, and a ninth depth is calculated, and an average value of calculated values at every positions is the average composition ratio. The first depth is a depth of 0.1d₁ (0.1 times d₁) in the direction toward the transparent electrode 2 from the surface of the p-type light-absorbing layer 4 on the n-type layer 5 side. The second depth is a depth of 0.2d₁ (0.2 times d₁) in the direction toward the transparent electrode 2 from the surface of the p-type light-absorbing layer 4 on the n-type layer 5 side. The third depth is a depth of 0.3d₁ (0.3 times d₁) in the direction toward the transparent electrode 2 from the surface of the p-type light-absorbing layer 4 on the n-type layer 5 side. The fourth depth is a depth of 0.4d₁ (0.4 times d₁) in the direction toward the transparent electrode 2 from the surface of the p-type light-absorbing layer 4 on the n-type layer 5 side. The fifth depth is a depth of 0.5d₁ (0.5 times d₁) in the direction toward the transparent electrode 2 from the surface of the p-type light-absorbing layer 4 on the n-type layer 5 side. The sixth depth is a depth of 0.6d₁ (0.6 times d₁) in the direction toward the transparent electrode 2 from the surface of the p-type light-absorbing layer 4 on the n-type layer 5 side. The seventh depth is a depth of 0.7d₁ (0.7 times d₁) in the direction toward the transparent electrode 2 from the surface of the p-type light-absorbing layer 4 on the n-type layer 5 side. The eighth depth is a depth of 0.8d₁ (0.8 times d₁) in the direction toward the transparent electrode 2 from the surface of the p-type light-absorbing layer 4 on the n-type layer 5 side. The ninth depth is a depth of 0.9d₁ (0.9 times d₁) in the direction toward the transparent electrode 2 from the surface of the p-type light-absorbing layer 4 on the n-type layer 5 side. For SIMS analysis, it is preferable to analyze the p-type light-absorbing layer 4 starting from a depth of 0.1d₁ because elements from the n-type layer 5 are easily detected when analyzing the surface of the p-type light-absorbing layer 4.

It is preferable that the p-type light-absorbing layer 4 be formed by a sputtering method, for example. More specifically, the substrate 1 on which the transparent electrode 2 is formed is heated to 300 [°C] or more and 1000 [°C] or less. The oxygen partial pressure is maintained within the range of 0.01 [Pa] or more and 4.8 [Pa] or less, while a deposition rate of 0.02 [µm/min] or more and 20 [µm/min] or less is used. From the viewpoint of forming a transparent polycrystalline film with a large grain size, when the deposition rate is represented by d, it is preferable that the oxygen partial pressure satisfy the following: 0.20 × d [Pa] or more and 1.00 × d [Pa] or less (for example, for high-temperature sputtering, 0.20 × d [Pa] or more and 0.50 × d [Pa] or less is preferable; for low-temperature sputtering, 0.55 × d [Pa] or more and 1.00 × d [Pa] or less is preferable). Further, a heating temperature of 350 [°C] or more and 500 [°C] or less is more preferable. Elements of M1 can be added during film formation.

The n-type layer 5 is an n-type semiconductor layer. The n-type layer 5 is disposed between the p-type light-absorbing layer 4 and the n-electrode 6. The n-type layer 5 is preferably provided on the p-type light-absorbing layer 4. For example, the n-type layer 5 can be formed by an ALD method.

The n-type layer 5 preferably includes a compound (oxide) with Ga as the main component. Other oxides may be mixed into the Ga-based oxide, other elements may be doped into the Ga-based oxide, or other elements may be doped into the Ga-based oxide and then mixed with other oxides. The n-type layer 5 may be a single layer or a multilayer. Among the metal elements contained in the n-type layer 5, it is preferable that Ga account for 40 [atomic%] or more, and more preferably 50 [atomic%] or more. The metal elements containing Ga in the n-type layer 5 may be inclined from the p-type light-absorbing layer 4 side to the n-electrode 6 side. When the n-type layer 5 is a multilayer semiconductor layer (for example, two layers), it is designated as a first n-type layer and a second n-type layer from the p-type light-absorbing layer 4 side. The amount of the element represented by M2 contained in the first n-type layer is smaller than the amount contained in the second n-type layer, preferably.

The n-type layer 5 preferably includes an oxide containing Ga and an element represented by M2. For example, the Ga-based oxide is an oxide containing Ga and an element represented by M2. The n-type layer 5 preferably includes an oxide containing Ga and an element represented by M2 selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr, and Nd. In the case of a multilayer n-type layer 5, for example, the first n-type layer may preferably contain 90 [wt%] or more and 100 [wt%] or less of an oxide containing Ga and one or more elements represented by M2 selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr, and Nd. The Ga-based compound in the n-type layer 5 is preferably an oxide containing M2 and Ga represented by the average composition Gaₕ₁M2ᵢ₁Oⱼ₁. h1, i1, and j2 preferably satisfy the following conditions: 1.8 ≤ h1 ≤ 2.1, 0.0 ≤ i1 ≤ 0.2, and 2.9 ≤ j1 ≤ 3.1. In the case of a multilayer n-type layer 5, for example, the n-type layer used as the second n-type layer may preferably be Zn-doped tin oxide.

It is preferable that the n-type layer 5 comprises, 90 [wt%] or more and 100 [wt%] or less of an oxide including M2 and Ga. More preferably, the n-type layer 5 comprises 95 [wt%] or more and 100 [wt%] or less of an oxide including M2 and Ga. Even more preferably, the n-type layer 5 is a compound represented by an oxide including M2 and Ga. The Cu included in the n-type layer 5 is not included in the raw materials for forming the n-type layer 5 but is diffused from the p-type light-absorbing layer 4 into the n-type layer 5. When other elements are used during the formation of the p-type light-absorbing layer 4, these elements may also diffuse into the n-type layer 5.

The thickness of the n-type layer 5 is typically 3 [nm] or more and 100 [nm] or less. When the thickness of the n-type layer 5 is less than 3 [nm], a leakage current may occur due to poor coverage of the n-type layer 5, which may degrade performance. The thickness is not limited to the above range when coverage is good. When the thickness of the n-type layer 5 exceeds 50 [nm], there is a risk that excessive high resistance of the n-type layer 5 will degrade performance or that a decrease in transmittance will lead to a decrease in short-circuit current. Therefore, a thickness of 3 [nm] or more and 20 [nm] or less is preferable for the n-type layer 5, and a thickness of 5 [nm] or more and 20 [nm] or less is even more preferable.

The n-electrode 6 is an electrode on the n-type layer 5 side that has light transmittance with respect to visible light. It is preferable that the n-electrode 6 be provided on the n-type layer 5. An intermediate layer not shown in the figure may be provided between the n-type layer 5 and the n-electrode 6. It is preferable to use an oxide transparent conductive film for the n-electrode 6. The oxide transparent conductive film used for the n-electrode 6 is preferably one or more semiconductor conductive films selected from the group consisting of indium tin oxide, aluminum-doped zinc oxide, boron-doped zinc oxide, gallium-doped zinc oxide, indium-doped zinc oxide, titanium-doped indium oxide, indium gallium zinc oxide and hydrogen-doped indium oxide. Dopants for films such as tin oxide are not particularly limited and can be selected from one or more elements from the group consisting of In, Si, Ge, Ti, Cu, Sb, Nb, Ta, W, Mo, F, and Cl. The n-electrode 6 may include mesh or line-shaped electrodes to reduce resistance in the oxide transparent conductive film. The mesh or line-shaped electrodes are not particularly limited and can be made of Mo, Au, Cu, Ag, Al, Ta, or W. Graphene can also be used for the n-electrode 6. It is preferable to laminate graphene with silver nanowires.

The thickness of the n-electrode 6 is determined by cross-sectional observation using an electron microscope or a step gauge. While not particularly limited, it is typically 50 [nm] or more and 2 [µm] or less.

It is preferable that the n-electrode 6 be formed by ALD or sputtering, for example.

The composition of compounds such as the p-type light-absorbing layer 4 and the n-type layer 5 is, unless otherwise specified, the average composition of the entire p-type light-absorbing layer 4 or n-type layer 5. For example, the composition of each layer can be determined by analyzing analysis spots (A1 to A9) in FIG. 2 using secondary ion mass spectrometry (SIMS), for example.

### (FOURTH EMBODIMENT)

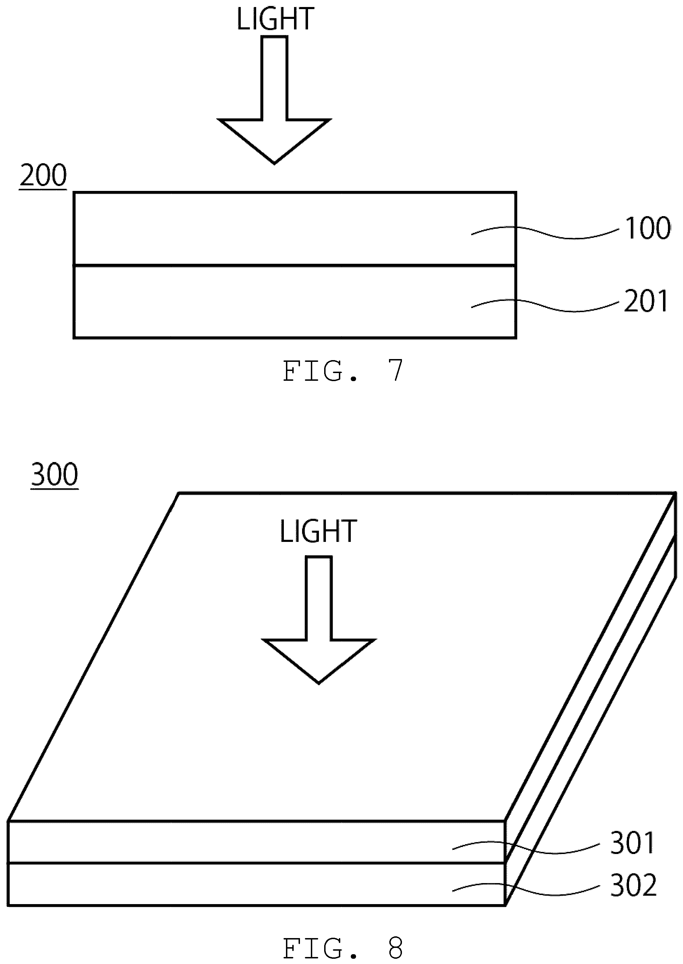

A fourth embodiment relates to a multi-junction solar cell. FIG. 7 shows a cross-sectional schematic diagram of the multi-junction solar cell according to this embodiment. The multi-junction solar cell 200 in FIG. 7 has a solar cell (a first solar cell) 100 according to the third embodiment on the light incident side and a second solar cell 201. The band gap of the light absorbing layer of the second solar cell 201 is smaller than the band gap of the p-type light-absorbing layer 4 of the first solar cell 100. The multi-junction solar cell 200 according to this embodiment may also include a solar cell consisting of three or more solar cells joined together.

The band gap of the p-type light absorbing layer (cuprous oxide) 3 of the first solar cell 100 (according to the third embodiment) is about 2.0 [eV] or more and 2.2 [eV] or less. Therefore, the band gap of the light absorbing layer of the second solar cell 201 is preferably 1.0 [eV] or more and 1.6 [eV] or less. As the light-absorbing layer of the second solar cell 201, one or more compound semiconductor layers selected from the group consisting of CIGS system and CdTe system with a high In content ratio, crystalline silicon, and perovskite type compounds are preferable.

### (FIFTH EMBODIMENT)

A fifth embodiment relates to a solar cell module. FIG. 8 shows a perspective diagram of the solar cell module 300 according to the fifth embodiment. The solar cell module 300 in FIG. 8 is a solar cell module where a first solar cell module 301 and a second solar cell module 302 are stacked. The first solar cell module 301 is on the light incident side and uses the first solar cell 100 according to the third embodiment. The second solar cell module 302 preferably uses the second solar cell 201.

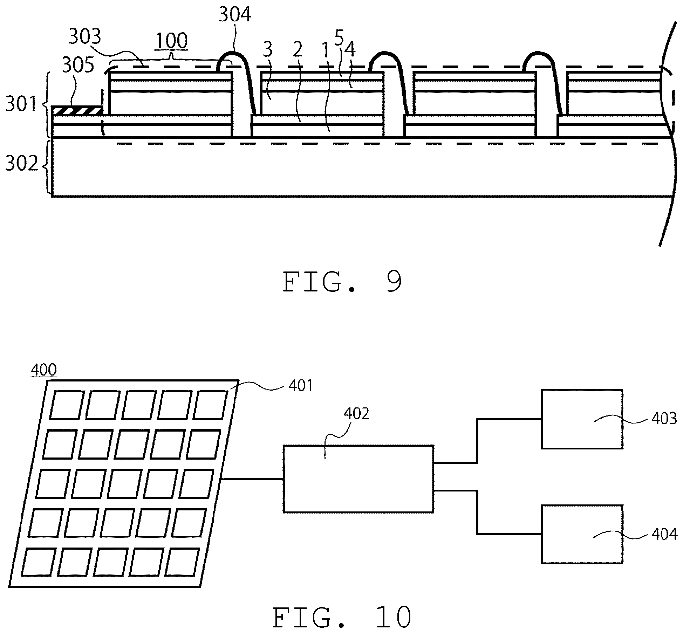

FIG. 9 shows a cross-sectional diagram of the solar cell module 300. FIG. 9 details the structure of the first solar cell module 301, but does not show the structure of the second solar cell module 302. The structure of the solar cell module can be selected appropriately according to the light-absorbing layer used in the solar cell employed in the second solar cell module 302. The solar cell module 300 in FIG. 9 includes a plurality of broken-line enclosed submodules 303, each including multiple solar cells 100 (solar cells) arranged side by side and electrically connected in series via wiring 304. These submodules 303 are further electrically connected in parallel or series. Adjacent submodules 303 are electrically connected by busbars 305.

Adjacent solar cells 100 have their n-electrode 6 on the upper side and transparent electrode 2 on the lower side connected by wiring 304. The solar cell 100 of the fifth embodiment, like that of the second embodiment, comprises the substrate 1, the transparent electrode 2, the insulating film 3, the p-type light absorbing layer 4, the n-type layer 5, and then n-electrode 6. The busbars 305 connect to both ends of the solar cells 100 in each submodule 303, and are configured to adjust the output voltage with the second solar cell module 302 by connecting multiple submodules 303 electrically in parallel or series. The connection configuration of the solar cell 100 shown in this fourth embodiment is just one example, and a solar cell module can be configured using other connection configurations.

### (SIXTH EMBODIMENT)

A sixth embodiment relates to a photovoltaic power generation system. The solar cell module of the fifth embodiment can be used as a generator for power generation in the photovoltaic power generation system of this embodiment. The photovoltaic power generation system of this embodiment generates electricity using a solar cell module and specifically includes a solar cell module that generates electricity, unit for converting the generated electricity into power, unit for storing the generated electricity (an accumulator), or a load for consuming the generated electricity. FIG. 10 shows a configuration diagram of the photovoltaic power generation system 400 according to this embodiment. The photovoltaic power generation system shown in FIG. 10 comprises a solar cell module 401 (300), a converter 402, a storage cell 403, and a load 404. Either the storage cell 403 or the load 404 may be omitted. The load 404 may also be configured to utilize electrical energy stored in the storage cell 403. The converter 402 is a device that includes a circuit or element for performing power conversion, such as voltage transformation or DC-AC conversion, including a DC-DC converter, a DC-AC converter, an AC-AC converter, etc. The configuration of the converter 402 should be appropriately selected according to the generation voltage or the configurations of the storage cell 403 and the load 404.

Electricity generated by solar cells included in the submodules 303 receiving light in the solar cell module 401 is converted by the converter 402 and stored in the storage cell 403 or consumed by the load 404. The solar cell module 401 may be provided with a solar tracking drive device for always directing the solar cell module 401 towards the sun, or a concentrator for focusing sunlight to improve the power generation efficiency.

The photovoltaic power generation system 400 is preferably used in real estate such as residences, commercial facilities, and factories, or movable property such as vehicles, aircraft, and electronic devices. By using a highly efficient solar cell according to this embodiment in the solar cell module, an increase in power generation can be expected.

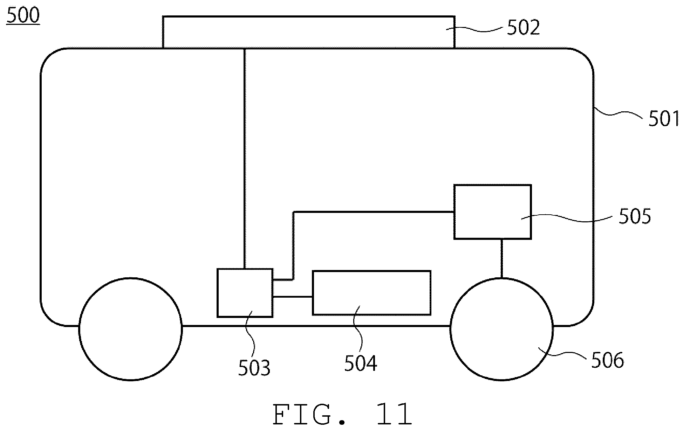

As an example of using the photovoltaic power generation system 400, a vehicle will be explained. FIG. 11 shows a conceptual diagram of the vehicle 500. The vehicle 500 shown in FIG. 11 includes a vehicle body 501, a solar cell module 502, a power conversion device 503, a storage cell 504, a motor 505, and tires (wheels) 506. Electricity generated by the solar cell module 502 mounted on the top of the car body 501 is converted by the power conversion device 503 and charged into the storage cell 504 or consumed as power by a load such as the motor 505. The vehicle 500 can be driven by rotating the tires (wheels) 506 with the motor 505 using electricity supplied from the solar cell module 502 or the storage cell 504. The solar cell module 502 may consist only of the first solar cell module equipped with the solar cell 100 according to the first embodiment, rather than a multi-junction type. When the transparent solar cell module 502 is adopted, it is also preferable to use the solar cell module 502 as a power generating window not only on the top of the vehicle body 501 but also on the side of the vehicle body 501.

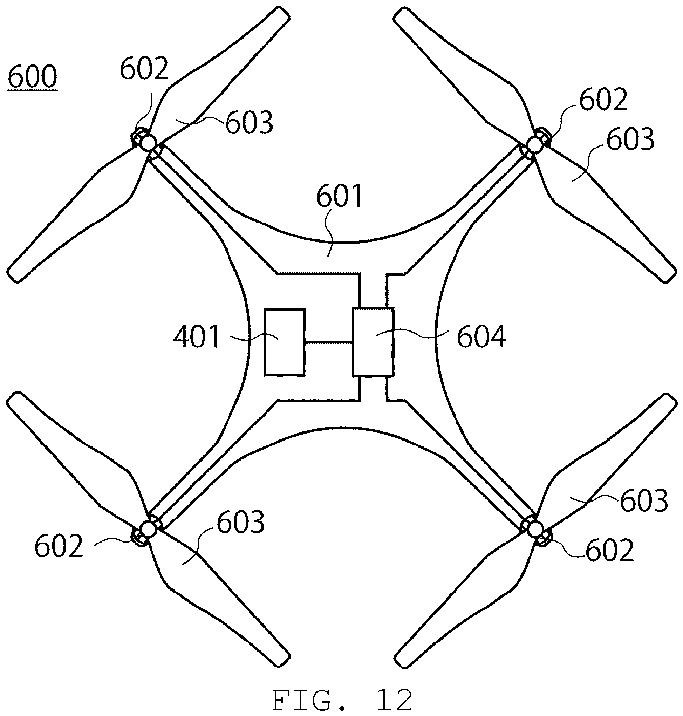

As an example of using the photovoltaic power generation system 400, a drone (quadcopter) will be explained. The drone uses the solar cell module 401. A simplified explanation of the configuration of the drone according to this embodiment will be given by referring to FIG. 12, a schematic diagram of the drone 600. The drone 600 comprises the solar cell module 401, a fuselage frame 601, a motor 602, a rotor 603, and a control unit 604. The solar cell module 401, the motor 602, the rotor 603, and the control unit 604 are arranged on the fuselage frame 601. The control unit 604 converts and adjusts the output power from the solar cell module 401. The motor 602 rotates the rotor 603 using the electricity supplied from the solar cell module 401. By adopting this configuration of the drone 600 with the solar cell module 401 according to this embodiment, it is possible to provide a drone capable of flying using more power.

Hereinafter, the present invention will be described in more detail with reference to examples, but the present invention is not limited to these examples.

### (EXAMPLE A)

### (Example A1)

On a white glass substrate 1, as a transparent electrode 2 on the back side, ITO (In:Sn = 80:20, film thickness 150 [nm]) and ATO (Sn:Sb = 98:2, film thickness 100 [nm]) are deposited on the side in contact with the glass. The thickness of the white glass substrate 1 is 0.5 [mm]. An insulating film 3 (SiO₂ : Na₂O: CaO = 7 : 2 : 1) is formed on the entire surface of the transparent electrode 2 by sputtering method, and the average film thickness is 10 [nm]. Then, a Cu₂O layer as a p-type absorbing layer 4 with a thickness of 6 [µm] is formed on the insulating film 3 by a sputtering method in an oxygen and argon gas atmosphere. After forming the p-type absorbing layer 4, a Ga₂O₃ film with a thickness of 10 [nm] is formed as an n-layer 5 (first n-layer). On the Ga₂O₃, a ZnSnO (Zn:Sn = 80:20) with a thickness of 14 [nm] is formed as a second n-layer. Finally, an AZO (ZnO:Al) with a thickness of 0.1 [µm] is formed as an n-electrode 6 to obtain a solar cell 100.

A solar simulator simulating an AM1.5G light source is used, and the light intensity is adjusted so that 1 sun is obtained using a standard Si cell under the light source. Measurement is conducted at atmospheric pressure with a room temperature of 25 [°C]. The voltage is swept, and the short-circuit current density Jsc (current divided by the cell area) is measured. On a graph with voltage on the horizontal axis and current density on the vertical axis, the point where the horizontal axis intersects is the open-circuit voltage Voc. On the measurement curve, when the product of voltage and short-circuit current density is maximized, these points are Vmpp and Jmpp (maximum power point), respectively. Then, FF = (Vmpp × Jmpp) / (Voc × Jsc) gives the fill factor. The conversion efficiency Eff. can be calculated from Eff. = Voc × Jsc × FF.

When the transmittance of light of the example A1 in the wavelength band of 700 [nm] or more and 1000 [nm] or less is 101% or more of the that of a comparison example, transmittance is evaluated as A. When the transmittance of light of the example A1 in the wavelength band is 95% or more and 101% or less of that of the comparison example, transmittance is evaluated as B. When the transmittance of light of the example A1 in the wavelength band is less than 95% of that of the comparison example, transmittance is evaluated as C. The evaluation of transmittance is common to Example A and examples other than Example A.

When Jsc of the example A1 is 1.04 times or more Jsc of the comparison example, Jsc is evaluated as A. When Jsc is of the example A1 is 1.00 times or more and less than 1.01 times Jsc of the comparison example, Jsc is evaluated as B. When Jsc of the example A1 is less than 1.00 times Jsc of the comparison example, Jsc is evaluated as C. The evaluation of Jsc is common to Example A and examples other than Example A.

When FF of the example A1 is 1.01 times or more FF of the comparison example, FF is evaluated as A. When FF is of the example A1 is 1.00 times or more and less than 1.01 times FF of the comparison example, FF is evaluated as B. When FF of the example A1 is less than 1.00 times FF of the comparison example, FF is evaluated as C. The evaluation of FF is common to Example A and examples other than Example A.

When the conversion efficiency of the example A1 is 1.05 times or more a conversion efficiency of the comparison example, the conversion efficiency is evaluated as A. When the conversion efficiency is of the example A1 is 1.00 times or more and less than 1.05 times the conversion efficiency of the comparison example, the conversion efficiency is evaluated as B. When the conversion efficiency of the example A1 is less than 1.00 times the conversion efficiency of the comparison example, FF is evaluated as C. The evaluation of the conversion efficiency is common to Example A and examples other than Example A.

### (Comparative Example A1)

On a white glass substrate 1, ITO (In:Sn = 80:20, film thickness 150 nm) and ATO (Sn:Sb = 98:2, film thickness 100 [nm]) are deposited as a transparent electrode 2 on the back side, with the glass in direct contact. The thickness of the white glass substrate 1 is 0.5 [mm]. Subsequently, a Cu₂O layer as a p-type absorbing layer 4 with a thickness of 6 [µm] is formed by a sputtering method in an oxygen and argon gas atmosphere on the ATO. After forming the p-type absorbing layer 4, a Ga₂O₃ film with a thickness of 10 [nm] is formed as an n-type layer 5 (first n-layer). On the Ga₂O₃, a ZnSnO (Zn:Sn = 80:20) layer with a thickness of 14 [nm] is formed as a second n-layer. Then, a solar cell 100 is obtained by forming an n-electrode 6 as AZO (ZnO:Al) with a thickness of 0.1 [µm]. The solar cell of Comparative Example A1 is evaluated in the same way as in Example A1.

### (Example A2)

A solar cell is obtained in the same manner as in Example A1, except that the transparent electrode 2 is formed so that the film thickness is 170 [nm] (ITO: 70 [nm], ATO: 100 [nm]). The solar cell of Example A2 is evaluated in the same manner as in Example A1.

### (Example A3)

A solar cell is obtained in the same manner as in Example A1 except that the transparent electrode 2 is formed so that the film thickness is 155 [nm] (ITO: 55 [nm], ATO: 100 [nm]). The solar cell of Example A3 is evaluated in the same manner as in Example A1.

### (Example A4)

A solar cell is obtained in the same manner as in Example A1, except that the transparent electrode 2 is formed so that the film thickness is 140 [nm] (ITO: 40 [nm], ATO: 100 [nm]). The solar cell of Example A4 is evaluated in the same manner as in Example A1.

### (Example A5)

A solar cell is obtained in the same manner as in Example A1, except that the transparent electrode 2 is formed so that the film thickness is 115 [nm] (ITO: 55 [nm], ATO: 60 [nm]). The solar cell of Example A5 is evaluated in the same manner as in Example A1.

### (Comparative Example A2)

A solar cell is obtained in the same manner as in Comparative Example A1, except that the transparent electrode 2 is formed so that the film thickness is 170 [nm] (ITO: 70 [nm], ATO: 100 [nm]). The solar cell of Comparative Example A2 is evaluated in the same manner as in Comparative Example A1.

### (Example A6)

A solar cell is obtained in the same manner as in Example A1 except that Al₂O₃ is deposited as an insulating film 3 by a sputtering method. The solar cell of Example A6 is evaluated in the same manner as in Example A1.

### (Example A7)

A solar cell is obtained in the same manner as in Example A2 except that Al₂O₃ is deposited as an insulating film 3 by a sputtering method. The solar cell of Example A7 is evaluated in the same manner as in Example A2.

### (Example A8)

A solar cell is obtained in the same manner as in Example A1 except that SiO₂ is deposited as an insulating film 3 by a sputtering method. The solar cell of Example A8 is evaluated in the same manner as in Example A1.

### (Example A9)

A solar cell is obtained in the same manner as in Example A2 except that SiO₂ is deposited as an insulating film 3 by a sputtering method. The solar cell of Example A9 is evaluated in the same manner as in Example A2.

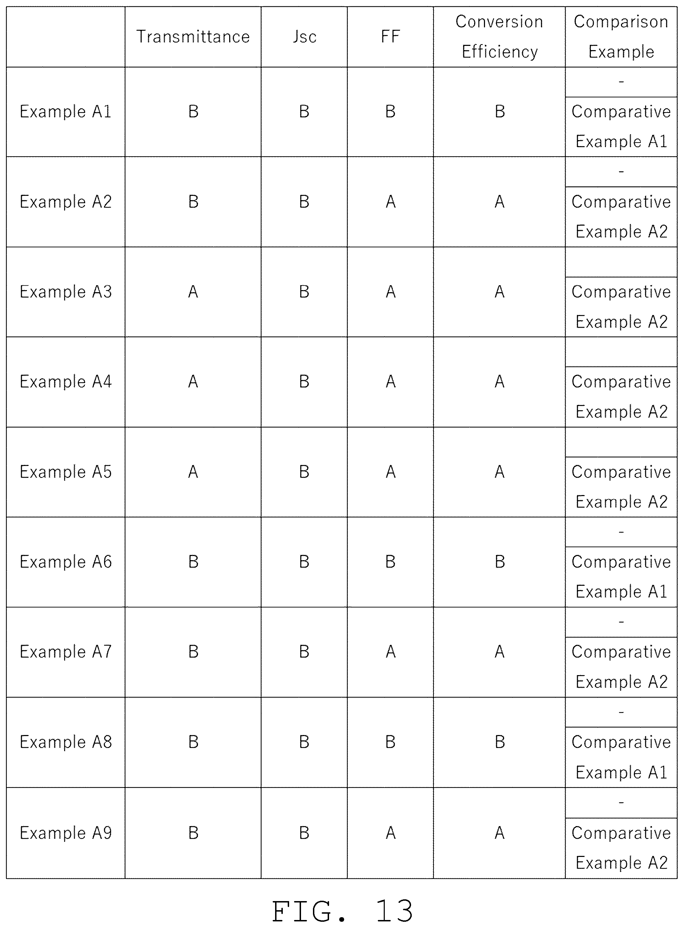

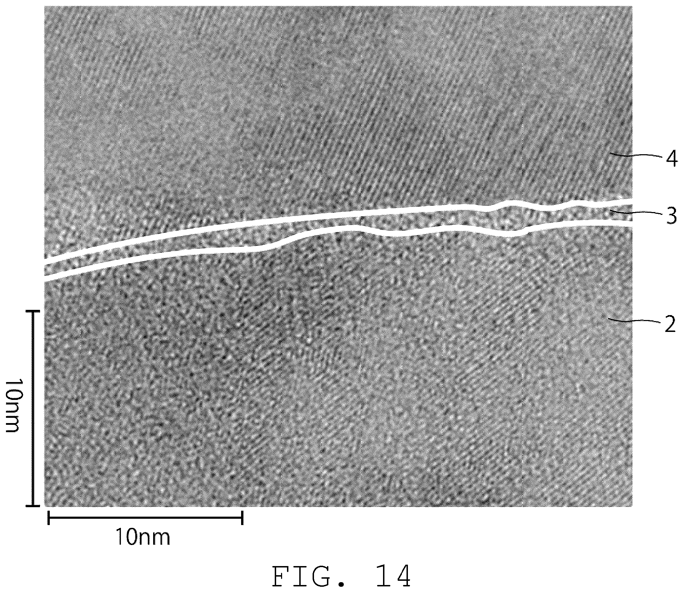

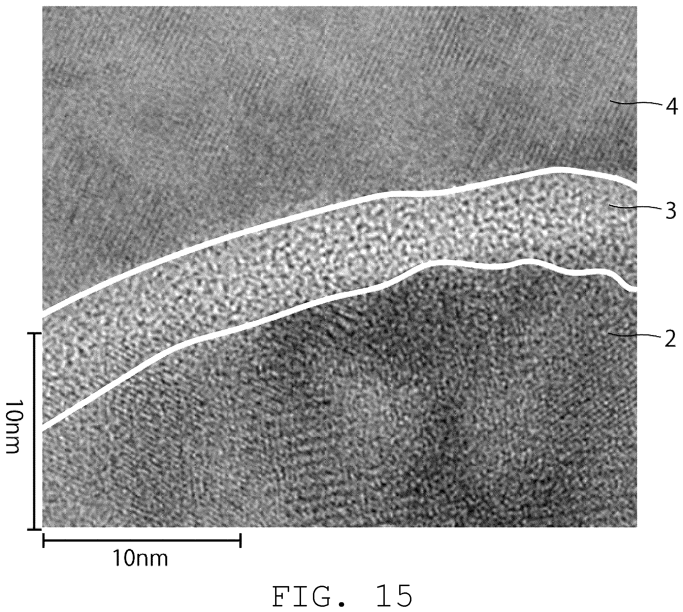

The evaluation results of the solar cell of Example A are shown in the table of FIG. 13. The insulating films 3 of Examples A1 to A6 each include both the thin sections and the thick sections, and the coverage rate is 50% or more and 100% or less. FIG. 14 and FIG. 15 show TEM images of the solar cell of Example 1. FIG. 14 shows a TEM image of a part where the insulating film 3 is thin. FIG. 15 shows a TEM image of a part where the insulating film 3 is thick.

As shown in the table of FIG. 13, it can be seen that all the solar cells provided with the insulating film 3 have improved conversion efficiency. With regard to the solar cell without the insulating film 3, the conversion efficiency of Comparative Example A1 (transparent electrode 2 with a thickness of 250 [nm]) is higher than that of Comparative Example A2 (transparent electrode 2 with a thickness of 170 [nm]), but by providing the insulating film 3, a solar cell with excellent conversion efficiency can be obtained even with a thinner transparent electrode 2. By providing the insulating film 3, the sheet resistance of the laminated body of the transparent electrode 2 and the insulating film 3 of the solar cell is lower than that of the transparent electrode 2 of the solar cell without the insulating film 3. Therefore, the Jsc of the Examples is superior to the comparative examples. Furthermore, by thinning the thickness of the transparent electrode 2, FF is improved. As a result, the conversion efficiency of the solar cell with a thin transparent electrode 2 and an insulating film 3 is effectively improved. In Example A, soda-lime glass, Al₂O₃, and SiO₂ are each used as the insulating film 3, and the effect of the insulating film 3 is confirmed for all materials.

### (EXAMPLE B)

### (Example B1)

On a white glass substrate 1, as a transparent electrode on the back side, ITO (In : Sn = 80 : 20, film thickness 150 [nm]) is deposited on the side in contact with the glass. The thickness of the white glass substrate 1 is 0.5 [mm]. An insulating film 3 (SiO₂ : Na₂O: CaO = 7 : 2 : 1) is formed on the entire surface of the transparent electrode 2 by a sputtering method, and the average film thickness is 10 [nm]. Then, a Cu₂O layer as a p-type light absorbing layer 4 with a thickness of 6 [µm] is formed on the insulating film 3 by a sputtering method in an oxygen and argon gas atmosphere. After the formation of the p-type light absorbing layer 4, a Ga₂O₃ film with a thickness of 10 [nm] is formed as n-type layer 5 (first n-layer). On the Ga₂O₃, a ZnSnO (Zn:Sn = 80 : 20) film with a thickness of 14 [nm] is formed as a second n-type layer. Finally, an n-electrode 6 is formed by depositing an AZO (ZnO : Al) film with a thickness of 0.1 [um], resulting in a solar cell 100. The solar cell of Example B2 is evaluated similarly to Example A1.

### (Comparative Example B1)

On a white glass substrate 1, as a transparent electrode on the back side, ITO (In : Sn = 80 : 20, film thickness 150 [nm]) is deposited on the side in contact with the glass. The thickness of the white glass substrate 1 is 0.5 [mm]. A Cu₂O layer as a p-type light absorbing layer 4 with a thickness of 6 [µm] is formed by a sputtering method in an oxygen and argon gas atmosphere on the ITO. After the formation of the p-type light absorbing layer 4, a Ga₂O₃ with a thickness of 10 [nm] is formed as an n-type layer 5 (first n-layer). A ZnSnO (Zn : Sn = 80 : 20) film with a thickness of 14 [nm] is formed on the Ga₂O₃ as a second n-type layer. Then, an n-electrode 6 is formed by depositing an AZO (ZnO:Al) film with a thickness of 0.1 [um], resulting in a solar cell 100. The solar cell of Comparative Example B2 is evaluated similarly to Example A1.

### (Example B2)

A solar cell is obtained in the same manner as in Example B1 except that Al₂O₃ is deposited as the insulating film 3 by a sputtering method. The solar cell of Example B2 is evaluated in the same manner as in Example A1.

### (Example B3)

A solar cell is obtained in the same manner as in Example B1 except that SiO₂ is deposited as the insulating film 3 by a sputtering method. The solar cell of Example B3 is evaluated in the same manner as in Example A1.

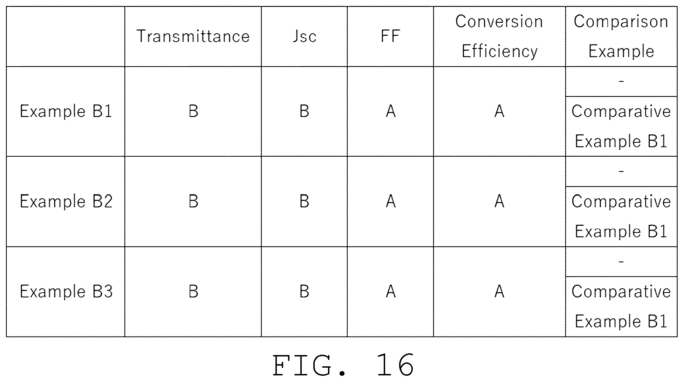

The evaluation results of the solar cells of Example B are shown in the table of FIG. 16. The insulating films 3 of Examples B1 to B3 each include both the thin sections and the thick sections, and the coverage rate is 50% or more and 100% or less. As shown in the table of FIG. 16, the conversion efficiency is improved even when a single film of ITO is used for the transparent electrode 2 as in Example A by providing the insulating film 3.

### (EXAMPLE C)

### (Example C1)

On a white glass substrate 1, as a transparent electrode on the back side, ITO (In : Sn = 80 : 20, film thickness 70 [nm]) and ATO (Sn : Sb = 98 : 2, film thickness 100 [nm]) are deposited on the side in contact with the glass. The thickness of the white glass substrate 1 is 0.5 [mm]. An insulating film 3 (SiO₂ : Na₂O : CaO = 7 : 2 : 1) is formed on the entire surface of the transparent electrode 2 by a sputtering method, and the average film thickness is 10 [nm]. Then, a Cu₂O layer as a p-type light absorbing layer 4 with a thickness of 6 [µm]is formed on the insulating film 3 by a sputtering method in an oxygen and argon gas atmosphere. After the formation of the p-type light absorbing layer 4, a Ga₂O₃ film with a thickness of 10 [nm] is formed an n-type layer 5 (first n-type layer). On the Ga₂O₃ film, a ZnSnO (Zn : Sn = 80 : 20) film with a thickness of 14 [nm] is formed as a second n-type layer. Finally, an n-electrode 6 is formed by depositing an AZO (ZnO:Al) film with a thickness of 0.1 [um], resulting in a solar cell 100.

### (Example C2)

A solar cell is obtained in the same manner as in Example C1 except that SiO₂ : Na₂O : CaO = 7: 2 : 1 is formed on the ATO as an insulating film 3 by a sputtering method so that the average film thickness is 8 [nm]. The solar cell of Example C2 is evaluated in the same manner as in Example A1.

### (Example C3)

A solar cell is obtained in the same manner as in Example C1 except that SiO₂ : Na₂O : CaO = 7: 2 : 1 is formed on the ATO as an insulating film 3 by a sputtering method so that the average film thickness is 5 [nm]. The solar cell of Example C3 is evaluated in the same manner as in Example A1.

### (Example C4)

A solar cell is obtained in the same manner as in Example C1 except that SiO₂ : Na₂O : CaO = 7: 2 : 1 is formed on the ATO as an insulating film 3 by a sputtering method so that the average film thickness is 3 [nm]. The solar cell of Example C4 is evaluated in the same manner as in Example A1.

### (Example C5)

A solar cell is obtained in the same manner as in Example C1 except that SiO₂ : Na₂O : CaO = 7: 2 : 1 is formed on the ATO as an insulating film 3 by a sputtering method so that the average film thickness is 1.5 [nm]. The solar cell of Example C5 is evaluated in the same manner as in Example A1.

### (Comparative Example C0)

A solar cell is obtained similarly to Example C1 except that the insulating film 3 is not formed. The solar cell of Comparative Example C0 is evaluated in the same manner as in Example A1.

### (Example C6)

A solar cell is obtained in the same manner as in Example C1 except that SiO₂ : Na₂O : CaO = 7: 2 : 1 is formed on the ATO as an insulating film 3 by a sputtering method so that the average film thickness is 1 [nm]. The solar cell of Example C5 is evaluated in the same manner as in Example A1.

### (Comparative Example C1)

A solar cell is obtained in the same manner as in Example C1 except that SiO₂ : Na₂O : CaO = 7: 2 : 1 is formed on the ATO as an insulating film 3 by a sputtering method so that the average film thickness is 100 [nm]. The solar cell of Comparative Example C1 is evaluated in the same manner as in Example A1.

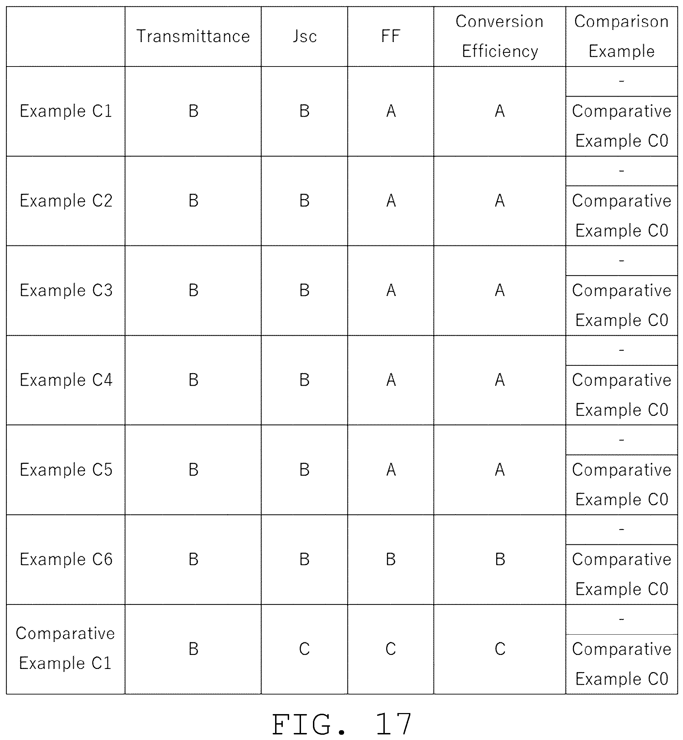

The evaluation results of the solar cells of Example C are shown in the table of FIG. 17. As shown in the table of FIG. 17, the conversion efficiency is improved when the thickness of the insulating film 3 to be formed is within the range of 1 [nm] to 10 [nm]. Moreover, when the thickness of the insulating film 3 to be formed becomes 100 [nm], the transparent electrode 2 is sandwiched between the thick insulating film 3 and the insulating substrate, so that the solar cell stops functioning.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

In the specification, some elements are represented only by chemical symbols for elements.

## Claims

1. A laminated body (10) comprising:
a substrate (1);
a transparent electrode (2) provided on the substrate (1); and
an insulating film (3) provided on the transparent electrode (2) which covers 50 % or more and 100% or less of a surface of the transparent electrode (2) on the opposite side of the substrate (2) and has a thinner thickness of a thickness of the substrate (1).

2. The laminated body (10) according to claim 1, wherein
a thickness of the insulating film (3) is 1 [nm] or more and 50 [nm] or less, and
an average thickness of the insulating film (3) is 1 [nm] or more and 30 [nm] or less.

3. The laminated body (10) according to claim 1, wherein
the average thickness of the insulating film (3) is 10⁻⁸ times or more and 10⁻³ times or less the thickness of the substrate (1),
the insulating film (3) is in direct contact with the transparent electrode (2), and
the insulating film (3) included one or more selected from the group consisting of SiO₂, Al₂O₃, SiN, SiON, and MgO.

4. The laminated body (10) according to claim 2, wherein
the entire surface of the insulating film (3) facing the transparent electrode (2) is in direct contact with the transparent electrode (2).

5. The laminated body (10) according to claim 2 or 4, wherein
the insulating film (3) includes SiO₂, Na₂O, and CaO.

6. The laminated body (10) according to any one of claims 1 to 5, wherein
the insulating film (3) is an amorphous film.

7. The laminated body (10) according to claim 1 or 3, wherein
the insulating film (3) covers 95 % or more and 100% or less of a surface of the transparent electrode (2) on the opposite side of the substrate (1).

8. The laminated body (10) according to claim 7, wherein
the insulating film (3) includes one or more selected from the group consisting of SiO₂, Na₂O, CaO, B₂O₃, Al₂O₃, SiN, SiON, and MgO, and
a total amount of one or more selected from the group consisting of SiO₂, Na₂O, CaO, B₂O₃, Al₂O₃, SiN, SiON, and MgO included in the insulating film (3) is 70 [wt%] or more and 100 [wt%] or less.

9. The laminated body (10) according to claim 7 or 8, wherein
the insulating film (3) includes one or more selected from the group consisting of SiO₂, Na₂O, CaO, B₂O₃, Al₂O₃, SiN, SiON, and MgO,
a total amount of one or more selected from the group consisting of SiO₂, Na₂O, CaO, B₂O₃, Al₂O₃, SiN, SiON, and MgO included in the insulating film (3) is 95 [wt%] or more and 90 [wt%] or less, and
a total amount of one or more selected from the group consisting of SiO₂, Al₂O₃, SiN, SiON, and MgO included in the insulating film (3) is 50 [wt%] or more and 100 [wt%] or less.

10. The laminated body (10) according to any one of claims 1 to 9, wherein
the insulating film (3) is soda-lime glass.

11. The laminated body (10) according to any one of claims 1 to 10, wherein
the insulating film (3) covers 99 % or more and 100% or less of a surface of the transparent electrode (2) on the opposite side of the substrate (1).

12. The laminated body (10) according to any one of claims 1 to 11, wherein
a side of the laminated body (10) opposite to the surface facing the transparent electrode (2) is exposed.

13. A solar cell (100) comprising:
the laminated body (10) according to any one of claims 1 and 3 to 11;
a p-type light-absorbing layer (4) provided on the insulating film (3);
an n-type layer (5) provided on the p-type light-absorbing layer (4); and
an n-electrode (6) on the n-type layer (5), wherein
the p-type light-absorbing layer (4) comprises a compound semiconductor.

14. The solar cell (100) according to claim 13, wherein
the insulating film (3) has thin sections and thick sections,
a thickness of the thin sections is 0.1 [nm] or more and less than 3.0 [nm],
a thickness of the thick sections is 3.0 [nm] or more and 20 [nm] or less,
a maximum thickness of the insulating film (3) is 15 [nm] more and 50 [nm] or less,
a ratio of the thin sections of the insulating film (3) is 10% or more and 90% or less,
a ratio of the thick sections of the insulating film (3) is 10% or more and 90% or less, and
an average thickness of the insulating film (3) is 1 [nm] or more and 15 [nm] or less.

15. The solar cell according to claim 13 or 14, wherein
the entire surface of the insulating film (3) facing the transparent electrode (2) is in direct contact with the transparent electrode (2),
the insulating film (3) has thin sections and thick sections,
a thickness of the thin sections is 0.1 [nm] or more and less than 3.0 [nm],
a thickness of the thick sections is 3.0 [nm] or more and 20 [nm] or less,
a maximum thickness of the insulating film (3) is 15 [nm] more and 50 [nm] or less,
a ratio of the thin sections of the insulating film (3) is 10% or more and 90% or less,
a ratio of the thick sections of the insulating film (3) is 10% or more and 90% or less,
an average thickness of the insulating film (3) is 1 [nm] or more and 15 [nm] or less,
the insulating film (3) is amorphous film,
the insulating film (3) includes one or more selected from the group consisting of SiO₂, Na₂O, CaO, B₂O₃, Al₂O₃, SiN, SiON, and MgO,
a total amount of one or more selected from the group consisting of SiO₂, Na₂O, CaO, B₂O₃, Al₂O₃, SiN, SiON, and MgO included in the insulating film (3) is 95 [wt%] or more and 90 [wt%] or less, and
a total amount of one or more selected from the group consisting of SiO₂, Al₂O₃, SiN, SiON, and MgO included in the insulating film (3) is 50 [wt%] or more and 100 [wt%] or less.
